# FASCICULE DE BREVET EUROPEEN

(11) **EP 3 161 178 B1**
(45) Date de publication et mention de la délivrance du brevet: **13.06.2018**
(21) Numéro de dépôt: 15732200.9
(22) Date de dépôt: 22.06.2015
(51) Int. Cl.: C23C 14/00, C23C 14/02, C23C 14/06, C23C 14/58, H01L 21/18, H01L 21/20, H01L 21/768, H01L 23/00, H01L 21/60, C23C 14/08

(54) **PROCEDE DE PASSIVATION ET PROCEDE DE COLLAGE DIRECT DE COUCHES DE TUNGSTENE**
WOLFRAMSCHICHTPASSIVIERUNGSVERFAHREN UND DIREKTES KLEBEVERFAHREN
TUNGSTEN LAYER PASSIVATION PROCESS AND DIRECT BONDING PROCESS

(30) Priorité: 24.06.2014 FR 1455848
(43) Date de publication de la demande: 03.05.2017
(73) Titulaire: Commissariat à l'Énergie Atomique et aux Énergies Alternatives, 75015 Paris (FR)
(72) Inventeur: BENAISSA, Lamine, 91300 Massy (FR); GONDCHARTON, Paul, 18150 GERMIGN L'EXEMPT (FR); IMBERT, Bruno, 38000 Grenoble (FR)
(74) Mandataire: Brevalex
(86) Numéro de dépôt international: PCT/EP2015/063932
(87) Numéro de publication internationale: WO 2015/197526

(56) Documents cités:
- US-A1- 2005 003 650
- US-A1- 2010 170 936
- INOUYE A ET AL: "Effects of composition and structure on hydrogen incorporation in tungsten oxide films deposited by sputtering", NUCLEAR INSTRUMENTS & METHODS IN PHYSICS RESEARCH, SECTION - B:BEAM INTERACTIONS WITH MATERIALS AND ATOMS, vol. 266, no. 15, 20 mai 2008 (2008-05-20) , pages 3381-3386, XP023437068, ELSEVIER, AMSTERDAM, NL ISSN: 0168-583X, DOI: 10.1016/J.NIMB.2008.05.008 [extrait le 2008-05-20]
- DATABASE INSPEC [Online] THE INSTITUTION OF ELECTRICAL ENGINEERS, STEVENAGE, GB; mars 2002 (2002-03), BITTENCOURT C ET AL: "Effects of oxygen partial pressure and annealing temperature on the formation of sputtered tungsten oxide films", XP002736021, Database accession no. 7193418 -& JOURNAL OF THE ELECTROCHEMICAL SOCIETY ELECTROCHEM. SOC. USA, vol. 149, no. 3, 8 février 2002 (2002-02-08), pages H81-H86, XP002736630, ISSN: 0013-4651, DOI: 10.1149/1.1448821

## Description

### DOMAINE TECHNIQUE

La présente invention concerne un procédé de passivation d'une couche de tungstène, et plus particulièrement un procédé de passivation d'une couche de tungstène formée par dépôt physique en phase vapeur (PVD, « Physical Vapor Deposition »). La présente invention concerne en outre un procédé de collage direct conducteur électrique de couches de tungstène.

### ÉTAT DE LA TECHNIQUE ANTÉRIEURE

Le cuivre est couramment utilisé comme matériau de formation des interconnexions. Toutefois, la résistivité du cuivre augmente de façon significative pour les films minces et les interconnexions fines. La conductivité du tungstène est alors supérieure à celle du cuivre.

Le tungstène présente en outre d'autres avantages par rapport au cuivre. Un avantage réside dans le fait que le tungstène est moins contaminant que le cuivre. Un autre avantage est lié au fait que le tungstène présente une température de fusion plus de deux fois supérieure à celle du cuivre (3695 K pour le tungstène contre 1358 K pour le cuivre). Il en résulte que le tungstène présente une meilleure tenue à haute température que le cuivre, ce qui est particulièrement avantageux pour certaines applications comme les applications de puissance. Il en résulte en outre que le tungstène est moins sensible à l'électro-migration que le cuivre.

Par ailleurs, les technologies basées sur l'empilement de puces ou de circuits sur plusieurs niveaux, couramment désignées par l'appellation « intégration 3D », permettent d'augmenter la densité d'intégration des composants et de réduire les longueurs des interconnexions.

Les technologies d'intégration 3D requièrent l'utilisation de procédés d'assemblage (ou de collage) pour former les différents niveaux. Les différentes étapes d'assemblage peuvent chacune correspondre à un assemblage de deux plaquettes semiconductrices (ou substrats semiconducteurs), ou à un assemblage d'une puce et d'une plaquette, ou à un assemblage de deux puces. Le report d'une couche semiconductrice ou d'une puce sur un étage précédent peut requérir en outre l'utilisation de procédés d'amincissement tels que les procédés de type Smart Cut™.

En outre, les technologies d'intégration 3D requièrent la formation d'interconnexions entre les différents niveaux. Ces interconnexions sont couramment réalisées par des vias remplis de matériau conducteur, couramment désignés par l'acronyme d'origine anglo-saxonne TSV (« Through Silicon Via »), traversant les différents étages de semiconducteur.

On cherche à utiliser du tungstène en tant que matériau composant les couches de collage et en tant que matériau assurant la conduction verticale entre les différents niveaux. On cherche notamment à réaliser un collage direct de deux couches de tungstène, c'est-à-dire sans apport de matière entre les surfaces à coller.

Pour cela, une solution consiste à réaliser un collage direct de deux couches de tungstène formées par dépôt chimique en phase vapeur (CVD, « Chemical Vapor Deposition »).

Un inconvénient d'un tel procédé réside dans le fait qu'il requiert la formation d'une sous-couche d'accroche (« seed layer » en anglais) pour la germination pour former la couche de tungstène par dépôt CVD. Cette sous-couche d'accroche, couramment en TiN, entraîne une réduction de la conductivité de l'ensemble formé par la sous-couche d'accroche et la couche de tungstène.

Un autre inconvénient d'un tel procédé réside dans le fait que l'énergie de collage est faible à température ambiante.

Un autre inconvénient d'un tel procédé réside dans le fait que la formation d'une couche de tungstène par dépôt CVD est réalisée à une température supérieure à 400 °C et requiert une densification à une température de l'ordre de 600 °C de la couche de tungstène formée. Un tel procédé peut donc difficilement être utilisé pour le collage de substrats comportant des composants avant le collage.

Une autre solution consiste à former les couches de tungstène par un procédé de type PVD.

Les procédés de dépôt PVD de tungstène présentent plusieurs avantages par rapport aux procédés de dépôt CVD.

Un avantage réside dans le fait que la pureté d'une couche de tungstène formée par dépôt PVD est supérieure à celle d'une couche de tungstène formée par dépôt CVD.

Un autre avantage réside dans le fait qu'un dépôt PVD de tungstène peut être effectué à température ambiante ou à basse température, ce qui n'est pas le cas d'un dépôt CVD.

Un autre avantage réside dans le fait qu'un dépôt PVD de tungstène ne requiert pas de formation préalable d'une sous-couche d'accroche. Il en résulte une meilleure conductivité d'une couche de collage en tungstène formée par PVD par rapport à une couche de collage formée par CVD.

Toutefois, les procédés de collage direct connus à température ambiante et pression atmosphérique de couches de tungstène formées par dépôt PVD ne permettent pas d'obtenir des énergies de collage suffisamment élevées.

En outre, des défauts apparaissent lors de traitements thermiques ultérieurs de l'assemblage, notamment pour des températures de l'ordre de 300 °C à 500 °C, ce qui correspond aux gammes de température couramment utilisées lors de la fracture d'un procédé de type Smart Cut™.

Ces problèmes de défectivité et d'énergie de collage sont attribués à la présence d'un oxyde de tungstène instable à l'interface de collage. Lors du collage, ce sont deux couches d'oxyde de tungstène qui sont mises en contact, et non pas deux couches de tungstène.

L'oxyde de tungstène instable présent à l'interface de collage peut avoir été formé au cours d'un procédé de polissage mécano-chimique de type CMP (« Chemical-Mechanical Polishing ») réalisé avant la mise en contact des couches de tungstène pour réduire leur rugosité de surface. L'oxyde de tungstène peut également avoir été formé par oxydation thermique ou encore par oxydation à température ambiante, par exemple par exposition à l'air, de l'une et/ou de l'autre des couches de tungstène. Dans tous les cas, il se forme une couche d'oxyde de tungstène natif instable sur chaque couche de tungstène lorsque les plaquettes sont exposées à l'air ambiant avant et pendant le collage.

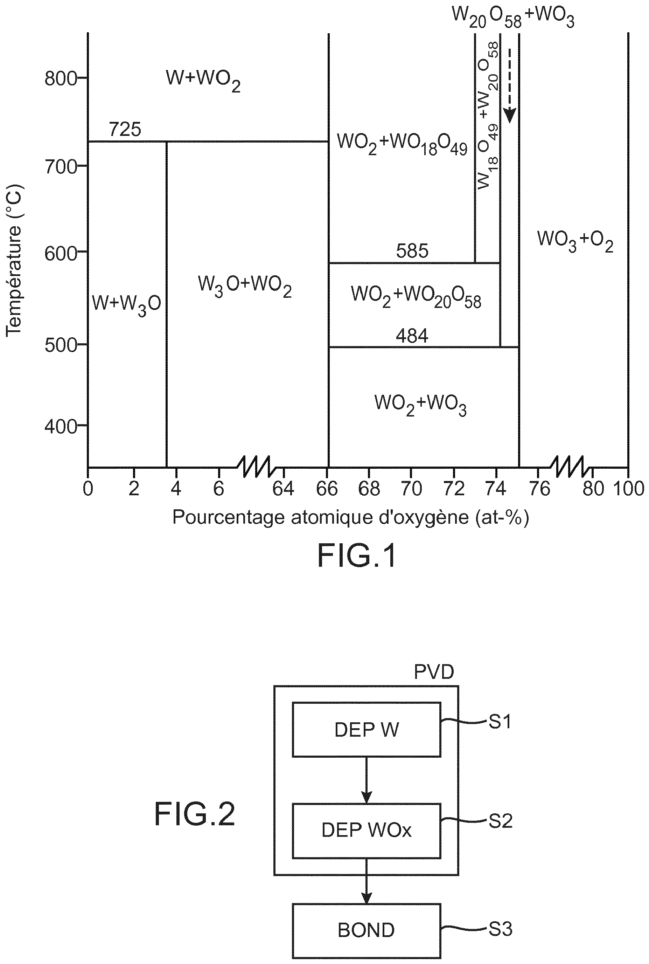

Comme l'illustre le diagramme de phase représenté sur la figure 1, la stoechiométrie de l'oxyde de tungstène est complexe. Il peut exister sous de nombreuses phases plus ou moins stables aux propriétés très différentes les unes des autres. En particulier, il existe des changements de phase de l'oxyde de tungstène selon la phase initiale pour des températures comprises dans la gamme de températures couramment utilisées pour les traitements thermiques de recuit après collage, ces changements de phase étant accompagnés de changements de volume. Un oxyde de tungstène formé au cours d'un procédé de CMP, par exemple dans des conditions de pH acide, peut être constitué d'un mélange instable de WO₂ et WO₃.

Une autre solution pour réaliser un collage direct de deux couches de tungstène consiste à utiliser un procédé de collage sous vide poussé couramment désigné dans la technique par l'acronyme d'origine anglo-saxonne SAB (« Surface Activated Bonding »). Un tel procédé consiste à bombarder sous vide poussé les surfaces à coller, par exemple par des ions argon. Le bombardement ionique entraîne une érosion des surfaces et peut, pour des couches de faible épaisseur (de l'ordre de 10 nm), dégrader les propriétés de conduction du tungstène du fait de l'amorphisation engendrée. Les surfaces sont ensuite collées, toujours sous vide poussé.

Un inconvénient d'un tel procédé réside dans le fait qu'il est coûteux et long à mettre en oeuvre. En outre, il requiert un contrôle de la contamination particulaire. De plus, il est difficile de détacher ultérieurement les deux couches de tungstène, ce qui rend difficile le recyclage des structures assemblées en cas de défauts.

Il se pose donc le problème de prévoir un procédé de collage direct de couches de tungstène permettant d'obtenir une énergie de collage accrue et une défectivité réduite.

Il se pose également le problème de prévoir un procédé de collage direct de couches de tungstène, les couches de collage présentant une résistivité réduite. Il se pose en outre le problème de prévoir un procédé de collage direct de couches de tungstène simple à mettre en oeuvre et peu coûteux. Le document de INOUYE A ET AL, de tirtre "Effects of composition and structure on hydrogen incorporation in tungsten oxide films deposited by sputtering", publié par NUCLEAR INSTRUMENTS & METHODS IN PHYSICS RESEARCH, SECTION - B:BEAM INTERACTIONS WITH MATERIALS AND ATOMS, ELSEVIER, à AMSTERDAM, dans de volume 266, no. 15, le 1 août 2008 08-01), aux pages 3381-3386, représente un document de l'art antérieur divulguant un procédé de formation d'une couche d'oxyde de tungstène consistant à déposer par dépôt PVD une couche d'oxyde de tungstène par pulvérisation réactive sous un plasma contenant du dioxygène, avec variation et contrôle de la pression partielle d'oxygène.

### EXPOSÉ DE L'INVENTION

La présente invention vise notamment à résoudre ces problèmes.

La présente invention concerne d'abord un procédé de formation et de passivation d'une couche de tungstène, comprenant les étapes suivantes réalisées successivement :
a) déposer par dépôt PVD une couche de tungstène sur un substrat ; et
b) déposer par dépôt PVD une couche d'oxyde de tungstène de passivation sur la couche de tungstène, par pulvérisation réactive sous un plasma contenant du dioxygène, la couche d'oxyde de tungstène telle que déposée étant amorphe et présentant une résistivité comprise entre 5.10⁻² et 5.10⁻³ Ω.cm, le substrat étant maintenu sous atmosphère inerte entre l'étape a) et l'étape b).

Par atmosphère inerte, on entend une atmosphère qui n'interagit pas avec la couche de tungstène, que ce soit pour l'oxyder ou la réduire.

Selon un mode de réalisation de la présente invention, l'étape a) de dépôt de la couche de tungstène et l'étape b) de dépôt de la couche d'oxyde de tungstène de passivation sont réalisées dans le même équipement de dépôt PVD sans remise à l'air.

Selon un mode de réalisation de la présente invention, lors de l'étape b), du dioxygène est introduit dans le plasma utilisé pour le dépôt de la couche de tungstène lors de l'étape a). Un tel procédé est couramment désigné par l'appellation anglo-saxonne de « reactive sputtering ».

Selon un mode de réalisation de la présente invention, lors de l'étape b), le plasma contient de l'argon et du dioxygène.

Selon un mode de réalisation de la présente invention, lors de l'étape b), le débit équivalent de dioxygène dans le plasma est compris entre 5 et 20 %.

Selon un mode de réalisation de la présente invention, lors de l'étape b), le débit d'argon dans le plasma est adapté pour que le débit équivalent de dioxygène dans le plasma reste compris entre 5 et 20 %.

Selon un mode de réalisation de la présente invention, la couche d'oxyde de tungstène déposée lors de l'étape b) présente une composition chimique « non stoechiométrique », intermédiaire entre celle de l'oxyde de tungstène de composition WO₃ et celle de l'oxyde de tungstène de composition WO₄.

L'épaisseur de la couche d'oxyde de tungstène déposée lors de l'étape b) peut être comprise entre 0,5 et 20 nm.

Lors de l'étape b), le dépôt de la couche d'oxyde de tungstène peut être réalisé par pulvérisation réactive en mode RF. Ceci permet d'éviter d'empoisonner la cible de tungstène pendant le dépôt.

La présente invention concerne en outre un procédé de collage direct d'un premier substrat et d'un second substrat, comprenant les étapes suivantes :
a') pour le premier et le second substrats, former une couche de tungstène recouverte d'une couche d'oxyde de tungstène de passivation par un procédé du type de celui décrit ci-dessus ; et
b') mettre en contact la couche d'oxyde de tungstène de passivation du premier substrat avec la couche d'oxyde de tungstène de passivation du second substrat.

Par collage direct, on entend la mise en contact de deux surfaces suffisamment lisses et propres pour créer une adhérence entre elles, sans apport de matière adhésive entre les deux surfaces. Le collage direct est une technique d'assemblage qui peut être réalisée à température ambiante et à pression atmosphérique.

La séparation des substrats par traction (premier mode de sollicitation mécanique) requiert alors une certaine énergie, appelée énergie de collage.

Le terme substrat peut désigner aussi bien une plaquette (wafer) qu'une puce. Un procédé de collage direct tel que celui décrit ci-dessus peut s'appliquer non seulement à un collage direct entre deux substrats mais également à un collage direct entre un substrat et une puce ou à un collage direct entre deux puces.

Un avantage d'un procédé de collage direct du type de celui décrit ci-dessus réside dans le fait qu'il permet d'obtenir une énergie de collage accrue. L'énergie de collage obtenue par un tel procédé est environ trois fois supérieure à celle obtenue par un procédé n'utilisant pas d'étape de passivation des couches de tungstène après leur formation par dépôt PVD et avant le collage.

Un autre avantage d'un tel procédé de collage direct réside dans le fait qu'il permet d'obtenir une défectivité réduite. Un tel procédé permet d'éviter l'apparition de défauts de collage lors d'un (ou d') éventuel(s) traitement(s) thermique(s) après l'étape b') de mise en contact. Par défauts de collage, on entend des défauts non détectables par microscopie acoustique en utilisant une tête de mesure émettant des ondes acoustiques à une fréquence inférieure à environ 30 MHz, ce qui correspond à une résolution latérale de l'ordre de 10 µm. La technique de microscopie acoustique est couramment désignée par l'acronyme d'origine anglo-saxonne SAM (« Scanning Acoustic Microscopy »).

Un autre avantage d'un tel procédé réside dans le fait que les dépôts des couches de tungstène et d'oxyde de tungstène peuvent être effectués à température ambiante. Un tel procédé peut donc être utilisé pour l'assemblage de substrats présentant déjà des composants et/ou ayant déjà subi une implantation ionique, par exemple en vue d'un transfert par un procédé de type Smart Cut™.

Un autre avantage d'un tel procédé réside dans le fait que la formation des couches de tungstène par dépôt PVD ne requiert pas de formation préalable de couches d'accroche.

Un autre avantage d'un tel procédé réside dans le fait qu'il permet d'obtenir une conductivité accrue pour les couches de collage formées de tungstène et d'oxyde de tungstène.

Un autre avantage d'un tel procédé réside dans le fait que l'oxyde de tungstène formé est stable pour des températures comprises entre la température ambiante et 1000 °C. Un tel procédé peut donc être utilisé pour former des dispositifs destinés à des applications de puissance.

Un autre avantage d'un tel procédé réside dans le fait qu'il est rapide et peu coûteux à mettre en oeuvre. En effet, la passivation de la couche de tungstène est réalisée dans le même équipement de dépôt PVD que le dépôt de la couche de tungstène, juste après le dépôt de la couche de tungstène.

Le procédé de collage direct décrit ci-dessus peut comprendre en outre une étape c') de traitement thermique de recuit après l'étape b') de mise en contact. Le traitement thermique peut être effectué à une température comprise entre environ 200 °C et la température de fusion la plus faible des matériaux en présence (par exemple environ 1400 °C pour le silicium), préférentiellement comprise entre environ 200 et 500 °C. Un tel traitement thermique de recuit après collage permet d'augmenter l'énergie de collage entre les premier et second substrats. Il permet en outre d'augmenter la conductivité verticale de l'assemblage.

Selon un mode de réalisation de la présente invention, lors de l'étape a'), on dépose une couche de tungstène sous la phase α.

Selon un mode de réalisation de la présente invention, lors de l'étape a'), on dépose une couche de tungstène comprenant au moins en partie du tungstène sous la phase β ; et lors de l'étape c'), le traitement thermique est effectué à une température supérieure à environ 100 °C afin de transformer le tungstène sous la phase β en tungstène sous la phase α.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
La figure 1 est un diagramme de phase de l'oxyde de tungstène.
La figure 2 est un diagramme représentant des étapes successives d'un procédé de collage direct de couches de tungstène selon l'invention.
Les figures 3A et 3B illustrent des résultats de mesures de défectivité par microscopie acoustique, après collage et après des traitements thermiques successifs, pour des débits équivalents de dioxygène de 0 %, 15 % et 25 % lors de l'étape de dépôt de la couche d'oxyde de tungstène de passivation.
La figure 4 représente des résultats de mesure de l'énergie de collage par insertion de lame en fonction de la température de traitement thermique de recuit après collage, pour des débits équivalents de dioxygène de 0 %, 15 % et 25 % lors de l'étape de dépôt de la couche d'oxyde de tungstène de passivation.
La figure 5 est une vue en coupe représentant de façon schématique un assemblage de deux substrats obtenu par un procédé de collage direct de couches de tungstène selon l'invention, des vias traversants assurant les connexions verticales entre les deux substrats.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les inventeurs proposent de réaliser une passivation in-situ d'une couche de tungstène formée par dépôt physique en phase vapeur (PVD, « Physical Vapor Deposition »). Ils proposent de former une couche de tungstène par dépôt PVD sur un substrat, puis, dans le même équipement de dépôt PVD et en maintenant le substrat sous vide secondaire, de former par pulvérisation réactive une couche d'oxyde de tungstène WOₓ de stoechiométrie contrôlée, stable en température, sur la couche de tungstène.

La figure 2 est un diagramme représentant des étapes successives d'un procédé de formation et de passivation d'une couche de tungstène par dépôt PVD.

On dépose sur un substrat, par exemple en silicium, une couche de tungstène par dépôt PVD, par exemple par pulvérisation (étape S1, « DEP W »).

Le dépôt de tungstène est effectué dans une chambre de pulvérisation d'un équipement de dépôt PVD, sous vide, par exemple sous un vide secondaire poussé à 10⁻⁷ Torr.

Le gaz inerte utilisé dans le plasma de gaz de travail est par exemple de l'argon. Eventuellement, le gaz inerte peut être du xénon. La cible est une cible de tungstène.

Le dépôt de la couche de tungstène peut être effectué en mode continu (DC) ou en mode alternatif (RF).

L'épaisseur de la couche de tungstène déposée est par exemple comprise entre 2 et 50 nm.

De préférence, la couche de tungstène est déposée sous la phase α. Selon une alternative, elle peut comprendre du tungstène sous la phase β; dans ce cas, on prévoira avantageusement un traitement thermique ultérieur de façon à transformer le tungstène sous la phase β en tungstène sous la phase α. Ce traitement thermique sera par exemple réalisé à une température supérieure à environ 100 °C.

A titre d'exemple d'ordre de grandeur de conditions de dépôt pour le dépôt de la couche de tungstène :
- la température est comprise entre 20 et 400 °C ;
- la pression partielle d'argon est comprise entre 0,1 et 100 mTorr (1 Torr correspond à 133,322 Pa) ;
- la puissance est comprise entre 10 et 5000 W ;
- la différence de potentiel appliquée (tension de polarisation) entre l'anode et la cathode de l'équipement de dépôt est comprise entre -200 V et 200 V.

Selon un exemple de réalisation, l'épaisseur de la couche de tungstène déposée est de l'ordre de 10 nm et les conditions de dépôt de la couche de tungstène sont les suivantes :
- la température est de l'ordre de 30 °C ;
- la pression partielle d'argon est de l'ordre de 1 mTorr ;
- la puissance est de l'ordre de 50 W;
- l'anode et la cathode sont au même potentiel.

On dépose ensuite une couche d'oxyde de tungstène de stoechiométrie contrôlée sur la couche de tungstène dans le même équipement de dépôt PVD, par pulvérisation réactive (étape S2, « DEP WOx »).

Le dépôt de la couche d'oxyde de tungstène est réalisé juste après le dépôt de la couche de tungstène, par exemple sans sortir le substrat de l'équipement et en maintenant le substrat sous vide secondaire. Selon une variante, on peut sortir le substrat de l'équipement entre l'étape de dépôt de la couche de tungstène et l'étape de dépôt de la couche d'oxyde de tungstène, tout en maintenant le substrat sous atmosphère inerte (ni oxydante, ni réductrice) entre ces deux étapes.

Le gaz inerte utilisé dans le plasma de gaz de travail est par exemple de l'argon. Eventuellement, le gaz inerte peut être du xénon. Le gaz réactif est du dioxygène. La cible est une cible de tungstène.

Avantageusement, le dépôt de la couche d'oxyde de tungstène est réalisé dans la même chambre de pulvérisation de l'équipement de dépôt PVD que celle utilisée pour le dépôt de la couche de tungstène. Dans ce cas, du dioxygène peut être incorporé dans le plasma de gaz de travail utilisé pour déposer la couche de tungstène en ouvrant une vanne d'arrivée de dioxygène pour alimenter le plasma de gaz de travail en dioxygène.

Le contrôle de la pression partielle de dioxygène dans le plasma permet de former une couche d'oxyde de tungstène WOₓ de stoechiométrie contrôlée, stable en température, sur la couche de tungstène. Une telle couche d'oxyde de tungstène forme une couche de passivation pour la couche de tungstène sous-jacente. La stoechiométrie obtenue pour la couche d'oxyde de tungstène dépendra notamment de la pression partielle de dioxygène.

Le fait de former une couche d'oxyde de tungstène de passivation sur la couche de tungstène juste après avoir formé la couche de tungstène, en maintenant le substrat sous atmosphère inerte, par exemple dans le même équipement sous vide, permet de ne pas exposer la couche de tungstène à l'air et donc d'éviter qu'il ne se forme une couche d'oxyde de tungstène natif instable sur la couche de tungstène.

La pression partielle de dioxygène dans le plasma sera par exemple choisie de façon à déposer une couche d'oxyde de tungstène amorphe de résistivité comprise entre environ 5.10⁻² et 5.10⁻³ Ω.cm, par exemple de l'ordre de 5,1.10⁻³ Ω.cm. Cela correspond à une couche d'oxyde de tungstène de densité comprise entre environ 6,7 et 6 g.cm⁻¹.

Le débit équivalent de dioxygène dans le plasma de gaz de travail, dans le cas où le plasma de gaz de travail contient de l'argon comme gaz inerte et du dioxygène comme gaz réactif, est défini par la relation suivante : % O₂ = D(O₂)/(D(O₂)+D(Ar D(O₂) et D(Ar) désignant respectivement les débits de dioxygène et d'argon.

Le dioxygène est par exemple incorporé dans le plasma selon un débit équivalent compris entre 5 et 20 %.

On forme par exemple une couche d'oxyde de tungstène de composition chimique WO₃₊ₓ avec 0 < x < 1, c'est-à-dire une couche de WO₃ enrichi en oxygène.

On forme par exemple une couche d'oxyde de tungstène de composition chimique comprise entre WO₃ et WO₄.

La phase de l'oxyde de tungstène tel que déposé est amorphe. La stabilité de l'oxyde de tungstène peut être renforcée par un traitement thermique de recuit permettant une recristallisation progressive de l'oxyde de tungstène. Le recuit de recristallisation de l'oxyde de tungstène est par exemple effectué à une température supérieure à environ 100 °C, par exemple comprise entre environ 100 et 500 °C, par exemple comprise entre environ 200 et 500 °C.

Avantageusement, le dépôt de la couche d'oxyde de tungstène par pulvérisation réactive est réalisé en mode RF. Ceci permet d'éviter d'empoisonner la cible de tungstène.

L'épaisseur de la couche d'oxyde de tungstène déposée est par exemple comprise entre 0,5 et 20 nm.

A titre d'exemple d'ordre de grandeur de conditions de dépôt pour le dépôt de la couche d'oxyde de tungstène :
- la température est comprise entre 20 et 400 °C ;
- le débit d'argon dans le plasma est compris entre 1 et 500 sccm (« Standard Cubic Centimeter per Minute ») ;
- pour un débit d'argon de 50 sccm, le débit de dioxygène dans le plasma est compris entre 2,6 et 12,5 sccm.

Selon un exemple de réalisation, l'épaisseur de la couche d'oxyde de tungstène déposée est de l'ordre de 5 nm et les conditions de dépôt de la couche d'oxyde de tungstène sont les suivantes :
- la température est de l'ordre de 30 °C ;
- le débit d'argon dans le plasma est de l'ordre de 50 sccm ;
- le débit de dioxygène dans le plasma est de l'ordre de 8,8 sccm.

Un procédé de formation et de passivation d'une couche de tungstène tel que celui décrit ci-dessus peut être utilisé pour former des couches de collage en vue de réaliser un collage direct conducteur électrique entre deux substrats.

Dans la description qui suit, le terme substrat peut désigner aussi bien une plaquette qu'une puce. Le procédé de collage direct conducteur électrique décrit ci-dessous peut s'appliquer non seulement à un collage direct entre deux substrats mais également à un collage direct entre un substrat et une puce ou à un collage direct entre deux puces.

On fournit d'abord deux substrats présentant chacun une rugosité moyenne (en RMS, « Root Mean Square ») inférieure à environ 1 nm sur une surface de 20 x 20 µm², par exemple de l'ordre de 0,4 nm RMS.

Dans un équipement de dépôt PVD, on procède ensuite directement aux étapes S1 et S2 décrites ci-dessus de dépôt d'une couche de tungstène puis de dépôt d'une couche d'oxyde de tungstène de passivation sur chacun des deux substrats.

On obtient ainsi sur chaque substrat une couche de collage formée d'une couche de tungstène recouverte d'une couche d'oxyde de tungstène de passivation.

Pour chaque couche de collage, l'homme du métier saura notamment choisir l'épaisseur de la couche de tungstène et celle de la couche d'oxyde de tungstène de façon à obtenir la conductivité voulue pour la couche de collage, notamment selon l'application visée.

On procède ensuite au collage direct des deux substrats par la mise en contact des couches de collage de chaque substrat, et plus précisément par la mise en contact des couches d'oxyde de tungstène de passivation de chaque substrat (étape S3, « BOND »).

L'étape S3 de mise en contact des couches d'oxyde de tungstène de chaque substrat est par exemple réalisée à température ambiante et à pression atmosphérique, sous air ambiant.

Avantageusement, on procède ensuite à un traitement thermique de recuit après collage. Le traitement thermique de recuit après collage est par exemple effectué à une température comprise entre environ 200 °C et la température de fusion la plus faible des matériaux en présence (par exemple environ 1400 °C pour le silicium), préférentiellement comprise entre environ 200 et 500 °C. Un tel traitement thermique de recuit après collage permet d'augmenter l'énergie de collage. Il permet en outre d'augmenter la conductivité verticale de l'assemblage.

Dans le cas où le budget thermique est faible pour le traitement thermique de recuit après collage, c'est-à-dire qu'il doit par exemple être effectué à une température inférieure à environ 100 °C, on déposera de préférence une couche de tungstène sous sa phase α lors de l'étape S1, car cette phase est plus stable et moins résistive.

Dans le cas où le budget thermique est plus élevé pour le traitement thermique de recuit après collage, c'est-à-dire qu'il peut par exemple être effectué à une température supérieure à environ 100 °C, on pourra déposer lors de l'étape S1 une couche de tungstène sous sa phase α ou sous sa phase β ou encore on pourra déposer une couche de tungstène comprenant du tungstène sous phase α et du tungstène sous phase β, car le tungstène sous phase β se transformera en tungstène sous phase α lors du traitement thermique.

Un avantage d'un procédé de collage direct du type de celui décrit en relation avec la figure 2 réside dans le fait qu'il permet d'obtenir une énergie de collage accrue. L'énergie de collage obtenue par un tel procédé est environ trois fois supérieure à celle obtenue par un procédé n'utilisant pas d'étape de passivation des couches de tungstène après leur formation par dépôt PVD et avant le collage.

Un autre avantage d'un tel procédé de collage direct réside dans le fait qu'il permet d'obtenir une défectivité réduite. Un tel procédé permet d'éviter l'apparition de défauts lors d'un (ou d') éventuel(s) traitement(s) thermique(s) après le collage.

Un autre avantage d'un tel procédé réside dans le fait que les dépôts des couches de tungstène et d'oxyde de tungstène peuvent être effectués à température ambiante ou à une température inférieure à celle des procédés de l'art antérieur. Un tel procédé peut donc être utilisé pour l'assemblage de substrats présentant déjà des composants.

Un autre avantage d'un tel procédé réside dans le fait que la formation des couches de tungstène par dépôt PVD ne requiert pas de formation préalable de couches d'accroche.

Un autre avantage d'un tel procédé réside dans le fait qu'il permet d'obtenir une conductivité accrue pour les couches de collage formées de tungstène et d'oxyde de tungstène.

Un autre avantage d'un tel procédé réside dans le fait que l'oxyde de tungstène formé est stable jusqu'à des températures d'environ 1000 °C. Un tel procédé peut donc être utilisé pour former des dispositifs destinés à des applications de puissance.

Un autre avantage d'un tel procédé réside dans le fait qu'il est rapide et peu coûteux à mettre en oeuvre. En effet, la passivation des couches de tungstène est réalisée dans le même équipement de dépôt PVD que le dépôt des couches de tungstène, juste après le dépôt des couches de tungstène.

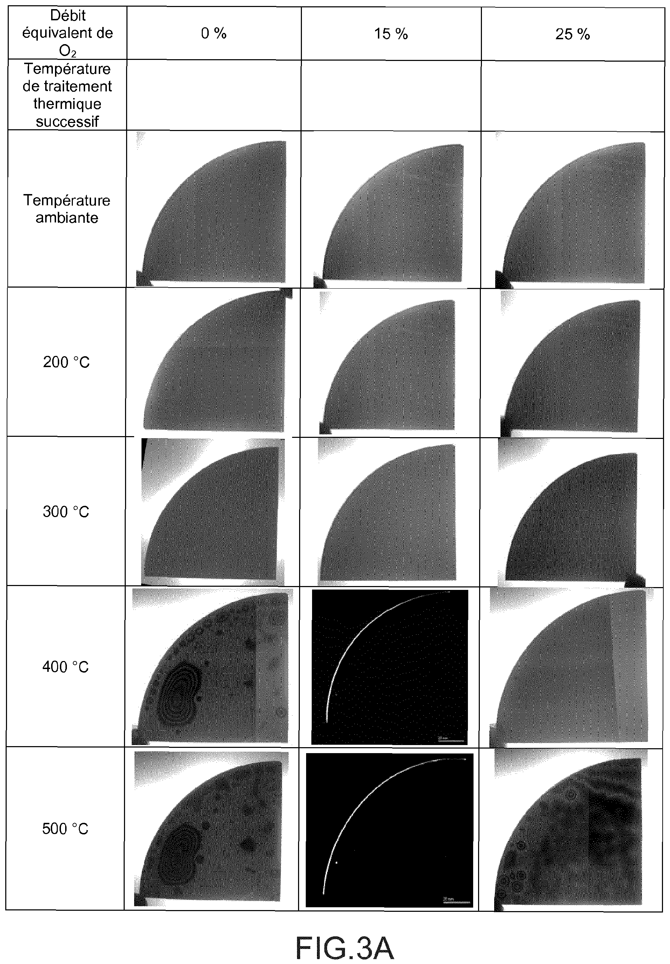

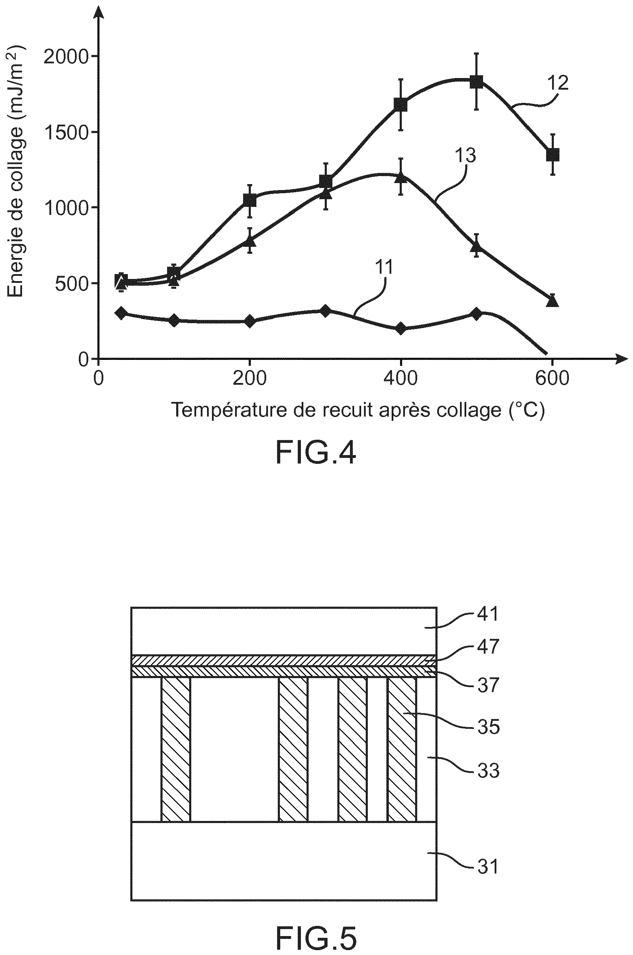

Les figures 3A-3B et 4 montrent des résultats de mesures de défectivité et d'énergie de collage effectuées sur des assemblages de substrats obtenus par un procédé tel que celui décrit en relation avec la figure 2.

Les substrats sont en silicium. Sur chaque substrat, une couche de collage, formée d'une couche de tungstène d'épaisseur de l'ordre de 10 nm recouverte d'une couche d'oxyde de tungstène d'épaisseur de l'ordre de 5 nm, a été formée avant le collage.

Les étapes S1 de dépôt de la couche de tungstène et S2 de dépôt de la couche d'oxyde de tungstène ont été réalisées dans une même chambre de pulvérisation d'un équipement de dépôt PVD de référence Alliance Concept CT200, sous un vide secondaire poussé de l'ordre de 10⁻⁷ Torr.

Le dépôt de la couche de tungstène et le dépôt de la couche d'oxyde de tungstène ont été réalisés sous un plasma de gaz de travail contenant comme gaz inerte de l'argon. Le dépôt de la couche d'oxyde de tungstène a été réalisé en mode RF. Le dépôt de la couche de tungstène peut être réalisé en mode RF ou DC.

Le dépôt de la couche d'oxyde de tungstène a été réalisé avec un débit d'argon de l'ordre de 50 sccm, avec incorporation de dioxygène comme gaz réactif dans le plasma de gaz de travail.

Le collage a été effectué manuellement, sous air ambiant et à température ambiante. Il a été mis en oeuvre rapidement après la remise à l'air des substrats après les étapes S1 de dépôt de la couche de tungstène et S2 de dépôt de la couche d'oxyde de tungstène de passivation. La durée d'attente entre la fin de l'étape S2 de dépôt de la couche d'oxyde de tungstène de passivation et le début de l'étape de collage est par exemple inférieure ou égale à 30 minutes.

Les mesures ont été réalisées après le collage et après différents traitements thermiques. Les traitements thermiques ont été réalisés sous air ambiant.

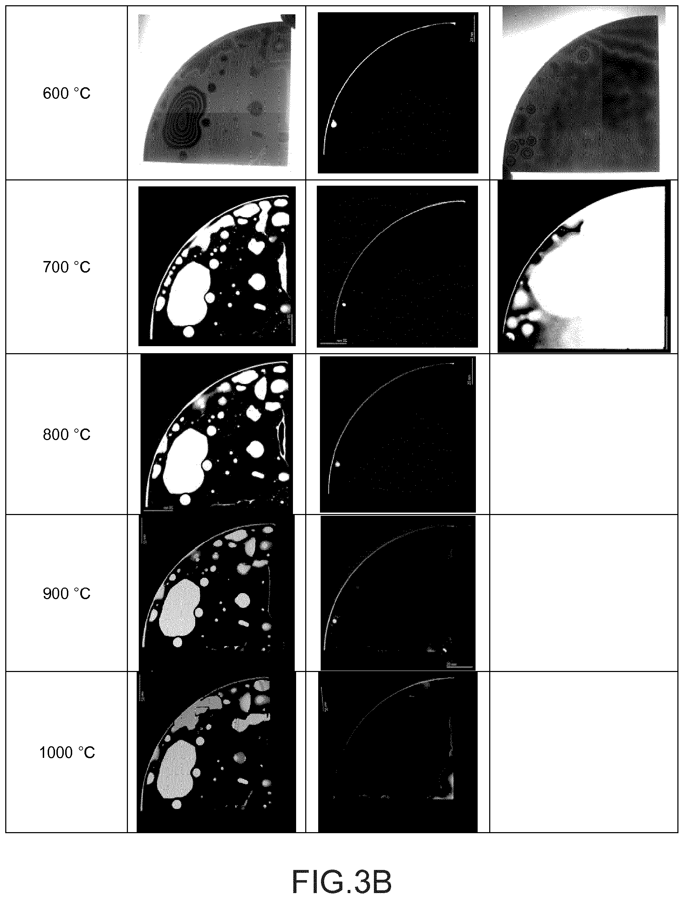

Les figures 3A et 3B illustrent des résultats de mesures de défectivité réalisées par microscopie acoustique, après le collage et après des traitements thermiques successifs. Les mesures ont été effectuées pour des débits équivalents de dioxygène de 0 %, 15 % et 25 % dans le plasma de gaz de travail.

Pour un débit équivalent de dioxygène de 0 %, c'est-à-dire dans le cas où on ne forme pas de couche d'oxyde de tungstène de passivation, des défauts apparaissent à partir d'une température supérieure à 300 °C.

Pour un débit équivalent de dioxygène de l'ordre de 25 %, des défauts apparaissent à partir d'une température supérieure à 400 °C. On observe un décollement des deux substrats pour une température supérieure à 700 °C.

Pour un débit équivalent de dioxygène de l'ordre de 15 %, seul un défaut particulaire de bord de plaque apparaît à une température de l'ordre de 400 °C et se résorbe à une température de l'ordre de 1000 °C. Hormis ce défaut particulaire de bord de plaque, aucun défaut n'apparaît après les différents traitements thermiques successifs.

Ces résultats confirment que la formation d'une couche d'oxyde de tungstène de passivation de stoechiométrie bien choisie sur chaque couche de tungstène, par un procédé du type de celui décrit en relation avec la figure 2, permet de minimiser l'apparition de défauts lors d'éventuels traitements thermiques réalisés après le collage.

La figure 4 représente des résultats de mesure de l'énergie de collage en fonction de la température de traitement thermique de recuit après collage. Les courbes 11, 12 et 13 correspondent respectivement à des débits équivalents de dioxygène dans le plasma de gaz de travail de 0 %, 15 % et 25 %.

Les énergies de collage ont été évaluées par la méthode d'insertion de lame, sous atmosphère anhydre, avec une incertitude de 10 %.

Pour un débit équivalent de dioxygène de 0 %, on remarque que l'énergie de collage est faible à température ambiante et reste faible et sensiblement constante en fonction de la température de recuit après collage. Dans le cas où on ne forme pas de couche d'oxyde de tungstène de passivation, un traitement thermique de recuit après collage ne permet pas d'augmenter l'énergie de collage.

Pour des débits équivalents de dioxygène de 15 % et 25 %, l'énergie de collage à température ambiante est sensiblement deux fois supérieure à celle obtenue avec un débit équivalent de dioxygène de 0 %. Les énergies de collage pour des débits équivalents de O₂ de 15 % et 25 % sont sensiblement égales. Ces résultats confirment que la formation d'une couche d'oxyde de tungstène de passivation permet d'augmenter l'énergie de collage à température ambiante.

Pour des débits équivalents de dioxygène de 15 % et 25 %, ces résultats confirment qu'un traitement thermique de recuit après collage permet d'augmenter de façon significative l'énergie de collage.

Pour un débit équivalent de O₂ de 25 %, on observe toutefois une diminution de l'énergie de collage pour des températures de recuit après collage supérieures à environ 400 °C. Cette chute de l'énergie de collage peut être attribuée à l'apparition de défauts (figure 3A). Pour des températures de recuit après collage supérieures à environ 400 °C, l'énergie de collage pour un débit équivalent de O₂ de 15 % est nettement supérieure à celle obtenue avec un débit équivalent de O₂ de 25 %.

Pour un débit équivalent de O₂ de 15 %, on observe une légère diminution de l'énergie de collage pour des températures de recuit supérieures à environ 500 °C. Toutefois, l'énergie de collage pour un tel débit équivalent de O₂ et pour des températures de recuit supérieures à 500 °C reste nettement supérieure à l'énergie de collage à température ambiante pour ce même débit équivalent de O₂.

Ces résultats confirment que la formation d'une couche d'oxyde de tungstène de passivation de stoechiométrie bien choisie sur chaque couche de tungstène, par un procédé du type de celui décrit en relation avec la figure 2, permet d'augmenter l'énergie de collage à température ambiante. Un traitement thermique de recuit après collage permet en outre d'augmenter de façon significative l'énergie de collage par rapport à l'énergie de collage obtenue à température ambiante.

L'homme du métier saura choisir le débit équivalent de dioxygène dans le plasma de gaz de travail et la température de recuit après collage en fonction de l'énergie de collage souhaitée.

La figure 5 est une vue en coupe représentant de façon schématique un exemple d'un assemblage de deux substrats pouvant être obtenu par un procédé de collage direct tel que celui décrit en relation avec la figure 2.

Une couche diélectrique 33 a été formée sur un substrat semiconducteur 31. Des vias traversants 35 remplis de tungstène ont été formés à travers la couche diélectrique 33. Une couche de collage 37, formée d'une couche de tungstène recouverte d'une couche d'oxyde de tungstène de passivation, a été formée sur la couche diélectrique 33.

Une couche de collage 47, formée d'une couche de tungstène recouverte d'une couche d'oxyde de tungstène de passivation, a été formée sur un autre substrat semiconducteur 41.

Les couches d'oxyde de tungstène de passivation de chaque couche de collage 37, 47 ont été mises en contact afin de réaliser un collage direct des deux substrats.

On obtient ainsi un assemblage de deux substrats semiconducteurs 31 et 41, les couches de collage 37 et 47 disposées entre les deux substrats étant électriquement conductrices. Les vias traversants 35 sont destinés à assurer les connexions verticales entre les deux substrats.

Du fait qu'un procédé du type de celui décrit en relation avec la figure 2 permet de minimiser l'apparition de défauts lors de traitements thermiques réalisés après le collage, on peut par exemple procéder après le collage à un amincissement du substrat 41 par un procédé de type Smart Cut™. Pour cela, on peut former une zone de fragilisation dans le substrat 41 avant de former la couche de collage 47. Après le collage, on peut alors détacher une partie du substrat 41 de l'assemblage, par fracture le long de la zone de fragilisation. La fracture peut être obtenue par un traitement thermique, par exemple effectué à une température comprise entre environ 300 °C et environ 500 °C.

## Revendications

1. Procédé de formation et de passivation d'une couche de tungstène, comprenant les étapes suivantes réalisées successivement :
a) déposer (S1) par dépôt PVD une couche de tungstène sur un substrat ; et
b) déposer (S2) par dépôt PVD une couche d'oxyde de tungstène de passivation sur la couche de tungstène, par pulvérisation réactive sous un plasma contenant du dioxygène, la couche d'oxyde de tungstène telle que déposée étant amorphe et présentant une résistivité comprise entre 5.10⁻² et 5.10⁻³ Ω.cm, le substrat étant maintenu sous atmosphère inerte entre l'étape a) et l'étape b).

2. Procédé selon la revendication 1, dans lequel l'étape a) de dépôt de la couche de tungstène et l'étape b) de dépôt de la couche d'oxyde de tungstène de passivation sont réalisées dans le même équipement de dépôt PVD sans remise à l'air.

3. Procédé selon la revendication 1 ou 2, dans lequel, lors de l'étape b), du dioxygène est introduit dans le plasma utilisé pour le dépôt de la couche de tungstène lors de l'étape a).

4. Procédé selon l'une des revendications 1 à 3, dans lequel, lors de l'étape b), le plasma contient de l'argon et du dioxygène.

5. Procédé selon la revendication 4, dans lequel, lors de l'étape b), le débit équivalent de dioxygène dans le plasma est compris entre 5 et 20 %.

6. Procédé selon l'une des revendications 1 à 5, dans lequel la couche d'oxyde de tungstène déposée lors de l'étape b) présente une composition chimique intermédiaire entre celle de l'oxyde de tungstène de composition WO₃ et celle de l'oxyde de tungstène de composition WO₄.

7. Procédé selon l'une des revendications 1 à 6, dans lequel l'épaisseur de la couche d'oxyde de tungstène déposée lors de l'étape b) est comprise entre 0,5 et 20 nm.

8. Procédé selon l'une des revendications 1 à 7, dans lequel, lors de l'étape b), le dépôt de la couche d'oxyde de tungstène est réalisé par pulvérisation réactive en mode RF.

9. Procédé de collage direct d'un premier substrat et d'un second substrat, comprenant les étapes suivantes :
a') pour le premier et le second substrats, former une couche de tungstène recouverte d'une couche d'oxyde de tungstène de passivation par un procédé selon l'une des revendications 1 à 8 ; et
b') mettre en contact (S3) la couche d'oxyde de tungstène de passivation du premier substrat avec la couche d'oxyde de tungstène de passivation du second substrat.

10. Procédé selon la revendication 9, comprenant en outre une étape c') de traitement thermique après l'étape b') de mise en contact, afin d'augmenter l'énergie de collage entre les premier et second substrats.

11. Procédé selon la revendication 9 ou 10, dans lequel, lors de l'étape a'), on dépose une couche de tungstène sous la phase α.

12. Procédé selon la revendication 10, dans lequel :
lors de l'étape a'), on dépose une couche de tungstène comprenant au moins en partie du tungstène sous la phase β ;
et lors de l'étape c'), le traitement thermique est effectué à une température supérieure à environ 100 °C afin de transformer le tungstène sous la phase β en tungstène sous la phase α.

## Patentansprüche

1. Verfahren zur Bildung und zur Passivierung einer Wolframschicht, umfassend die folgenden Schritte, welche nacheinander durchgeführt werden:
a) Aufbringen (S1) durch PVD-Aufbringen von einer Wolframschicht auf ein Substrat, und
b) Aufbringen (S2) durch PVD-Aufbringen einer Passivierungsschicht aus Wolframoxid auf die Wolframschicht durch reaktives Zerstäuben unter einem Plasma, welches Disauerstoff enthält, wobei die so aufgebrachte Wolframoxidschicht amorph ist und eine Resistivität umfasst zwischen 5·10⁻² und 5·10⁻³ Ω·cm aufweist, wobei das Substrat zwischen Schritt a) und Schritt b) unter einer inerten Atmosphäre gehalten wird.

2. Verfahren gemäß Anspruch 1, in welchem Schritt a) des Aufbringens der Wolframschicht und Schritt b) des Aufbringens der Passivierungsschicht aus Wolframoxid mit derselben Ausrüstung zum PVD-Aufbringen ohne Lagerung an der Luft durchgeführt werden.

3. Verfahren gemäß Anspruch 1 oder 2, in welchem während des Schritts b) Disauerstoff in das Plasma eingebracht wird, welches zum Aufbringen der Wolframschicht während des Schritts a) verwendet wird.

4. Verfahren gemäß einem der Ansprüche 1 bis 3, in welchem während des Schritts b) das Plasma Argon und Disauerstoff enthält.

5. Verfahren gemäß Anspruch 4, in welchem während des Schritts b) die Durchsatzrate des Disauerstoffs im Plasma zwischen 5 und 20 % umfasst ist.

6. Verfahren gemäß einem der Ansprüche 1 bis 5, in welchem die Wolframoxidschicht, welche während des Schritts b) aufgebracht wird, eine chemische Zusammensetzung aufweist, welche zwischen der des Wolframoxids der Zusammensetzung WO₃ und der des Wolframoxids der Zusammensetzung WO₄ lieg.

7. Verfahren gemäß einem der Ansprüche 1 bis 6, in welchem die Dicke der Wolframoxidschicht, die während des Schritts b) aufgebracht wird, zwischen 0,5 und 20 nm umfasst ist.

8. Verfahren gemäß einem der Ansprüche 1 bis 7, in welchem in Schritt b) das Aufbringen der Wolframoxidschicht durch reaktives Zerstäuben im RF-Modus durchgeführt wird.

9. Verfahren zum Direktkleben eines ersten Substrats und eines zweiten Substrats, umfassend die folgenden Schritte:
a') Bilden einer Wolframschicht, welche von einer Passivierungssicht aus Wolframoxid abgedeckt ist, durch ein Verfahren gemäß einem der Ansprüche 1 bis 8 für das erste und das zweite Substrat, und
b') Inkontaktbringen (S3) der Passivierungsschicht aus Wolframoxid des ersten Substrats mit der Passivierungsschicht aus Wolframoxid des zweiten Substrats.

10. Verfahren gemäß Anspruch 9, umfassend außerdem einen Schritt c') zur thermischen Behandlung nach Schritt b') des Inkontaktbringens, so dass die Klebungsenergie zwischen dem ersten und dem zweiten Substrat erhöht wird.

11. Verfahren gemäß Anspruch 9 oder 10, in welchem während des Schritts a') eine Wolframschicht in einer α-Phase aufgebracht wird.

12. Verfahren gemäß Anspruch 10, in welchem:
während des Schritts a') eine Wolframschicht, umfassend wenigstens einen Teil des Wolframs in einer β-Phase aufgebracht wird,
und während des Schritts c') die thermische Behandlung bei einer Temperatur oberhalb von etwa 100 °C durchgeführt wird, um das Wolfram in β-Phase in ein Wolfram der α-Phase umzuwandeln.

## Claims

1. Method for the formation and passivation of a tungsten layer, comprising the following steps performed successively:
a) depositing (S1) by PVD a layer of tungsten on a substrate; and
b) depositing (S2) by PVD a tungsten oxide passivation layer on the tungsten layer, by reactive sputtering in a plasma containing dioxygen, the tungsten oxide layer as deposited being amorphous and having a resistivity of between 5.10⁻² and 5.10⁻³ Ω.cm, the substrate being kept in an inert atmosphere between step a) and step b).

2. Method according to claim 1, in which step a) of depositing the tungsten layer and step b) of depositing the tungsten oxide passivation layer are performed in the same PVD equipment without bringing into the open air.

3. Method according to claim 1 or 2, in which, during step b), dioxygen is introduced into the plasma used for the deposition of the tungsten layer during step a).

4. Method according to one of claims 1 to 3, in which, during step b), the plasma contains argon and dioxygen.

5. Method according to claim 4, in which, during step b), the equivalent flowrate of dioxygen in the plasma is between 5% and 20%.

6. Method according to one of claims 1 to 5, in which the layer of tungsten oxide deposited during step b) has a chemical composition intermediate between that of tungsten oxide of composition WO₃ and that of tungsten oxide of composition WO₄.

7. Method according to one of claims 1 to 6, in which the thickness of the layer of tungsten oxide deposited during step b) is between 0.5 and 20 nm.

8. Method according to one of claims 1 to 7, in which, during step b), the deposition of the tungsten oxide layer is carried out by reactive sputtering in RF mode.

9. Method for the direct bonding of a first substrate and a second substrate, comprising the following steps:
a') for the first and second substrates, forming a tungsten layer covered with a tungsten oxide passivation layer by means of a method according to one of claims 1 to 8; and
b') putting (S3) the tungsten oxide passivation layer of the first substrate in contact with the tungsten oxide passivation layer of the second substrate.

10. Method according to claim 9, further comprising a step c') of heat treatment after step b') of putting in contact, in order to increase the bonding energy between the first and second substrates.

11. Method according to claim 9 or 10, in which, during step a'), a layer of tungsten in α phase is deposited.

12. Method according to claim 10, in which:
during step a'), a tungsten layer comprising at least partly tungsten in β phase is deposited;
and, during step c'), the heat treatment is carried out at a temperature above approximately 100°C in order to transform the tungsten in β phase into tungsten in α phase.
